(19) Europäisches Patentamt / European Patent Office / Office européen des brevets

(11) **EP 2 040 268 A1**

(12) **EUROPEAN PATENT APPLICATION**
published in accordance with Art. 153(4) EPC

(43) Date of publication:
**25.03.2009 Bulletin 2009/13**

(51) Int Cl.:
*H01B 5/00* (2006.01)    *C09J 9/02* (2006.01)
*C09J 11/00* (2006.01)    *C09J 201/00* (2006.01)
*H01B 1/20* (2006.01)    *H05K 3/32* (2006.01)

(21) Application number: **07741414.2**

(22) Date of filing: **11.04.2007**

(86) International application number:
**PCT/JP2007/057978**

(87) International publication number:
**WO 2008/004367 (10.01.2008 Gazette 2008/02)**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(30) Priority: **03.07.2006 JP 2006183619**

(71) Applicant: **Hitachi Chemical Company, Ltd. Tokyo 163-0449 (JP)**

(72) Inventors:
• **TANAKA, Masaru**
  **Chikusei-shi**
  **Ibaraki 308-8524 (JP)**
• **TAKETATSU, Jun**
  **Chikusei-shi**
  **Ibaraki 308-8524 (JP)**

(74) Representative: **Jönsson, Hans-Peter**
  **Patentanwälte von Kreisler Selting Werner**
  **Deichmannhaus am Dom**
  **Bahnhofsvorplatz 1**
  **50667 Köln (DE)**

(54) **CONDUCTIVE PARTICLE, ADHESIVE COMPOSITION, CIRCUIT-CONNECTING MATERIAL, CIRCUIT-CONNECTING STRUCTURE, AND METHOD FOR CONNECTION OF CIRCUIT MEMBER**

(57)    The conductive particle of the invention each comprises a conductive nucleus particle and an insulating coating containing an organic high molecular compound on the surface of the nucleus particle, and the coverage factor as defined by the following formula (1) is in the range of 20-40%.

$$\text{Coverage factor (\%)} = \frac{\left[ \begin{array}{c} \text{Area of sections on nucleus particle} \\ \text{surface covered with insulating coating} \end{array} \right]}{\left[ \text{Total surface area of nucleus particle} \right]} \times 100 \quad (1)$$

**Fig.3**

EP 2 040 268 A1

## Description

## Technical Field

The present invention relates to conductive particles, an adhesive composition, a circuit-connecting material and a connection structure, as well as to a circuit member connecting method.

## Background Art

Methods used for mounting of liquid crystal driving ICs on liquid crystal display glass panels include Chip-On-Glass mounting (hereinafter abbreviated as "COG mounting") and Chip-On-Flex mounting (hereinafter abbreviated as "COF mounting"). COG mounting is a method in which the liquid crystal driving IC is directly bonded to the glass panel. COF mounting, on the other hand, is a method in which the liquid crystal driving IC is bonded to a flexible tape with metal wiring, and the bonded structure is then bonded to the glass panel.

In COG mounting and COF mounting, it is common to use an adhesive composition with anisotropic conductivity as the circuit-connecting material. The adhesive composition is obtained by dispersing conductive particles in an adhesive component.

With the increasingly high definition of liquid crystal displays in recent years, there has been a trend toward narrow pitches and smaller areas for the metal wirings of bumps and flexible tapes as electrodes in liquid crystal driving ICs. In conventional adhesive compositions, therefore, the number of conductive particles lying between the circuit electrodes that are to be connected is insufficient, such that a high resistance value at the connected sections is a commonly faced problem.

However, when the conductive particle content of the adhesive composition is increased in order to avoid this problem, insulation between adjacent circuit electrodes can become insufficient.

Patent document 1 describes means for improving the connection reliability, with a connecting member having an insulating adhesive layer formed on one side of an adhesive layer containing conductive particles. Also, Patent documents 2 and 3 describe techniques using conductive particles whose surfaces are covered with an insulating coating.

[Patent document 1] Japanese Unexamined Patent Publication HEI No. 08-279371
[Patent document 2] Japanese Patent Publication No. 2794009
[Patent document 3] Japanese Unexamined Patent Publication No. 2001-195921

## Disclosure of the Invention

## Problem to be Solved by the Invention

The connecting member described in Patent document 1 provides the effect of both the low resistance value of the connected section and the insulation between the adjacent circuit electrodes. For cases where the bump area is very small (for example, less than 3000 $\mu$m$^2$), however, the connecting member is in need of improvement in order to achieve the aforementioned effect in a sufficiently stable manner.

When particles whose entire surfaces are covered with an insulating coating are used, such as the conductive particles described in Patent documents 2 and 3, insulation between adjacent circuit electrodes is usually maintained. However, the resistance value at the connected sections cannot be adequately reduced when such conductive particles are used, and therefore the problem of a gradually increasing resistance value arises.

It is an object of the present invention, which has been accomplished under such circumstances, to provide conductive particles that can provide a sufficiently low initial resistance value at connected sections and excellent insulation between adjacent circuit electrodes, when circuit members comprising fine-sized circuit electrodes are connected together, and that adequately inhibit increase in the resistance value of the connected sections with time, as well as an adhesive composition and a circuit-connecting material employing the foregoing.

It is another object of the invention to provide a connection structure in which circuit members are connected using the aforementioned circuit-connecting material, and a circuit member connecting method by which the structure can be obtained.

## Means for Solving the Problem

The conductive particle of the invention comprises a conductive nucleus particle and an insulating coating containing an organic high molecular compound on the surface of the nucleus particle, wherein the coverage factor as defined by the following formula (1) is in the range of 20-40%.

$$\text{Coverage factor (\%)} = \frac{\left[ \begin{array}{c} \text{Area of sections on nucleus particle} \\ \text{surface covered with insulating coating} \end{array} \right]}{\left[ \text{Total surface area of nucleus particle} \right]} \times 100 \quad (1)$$

The conductive particles of the invention are provided with an insulating coating with a coverage factor in the range of 20-40%. A coverage factor of 20-40% for the conductive particles will allow the conductive particles to be present in the adhesive component in a sufficient amount to obtain a low initial resistance value. Even if aggregation of the conductive particles occurs with increasing conductive particle content, the insulating coating on the conductive particles can adequately prevent electrical connection between adjacent circuit electrodes.

When conductive particles entirely covered with an insulating coating are used, the insulating coating is present between the nucleus particles and circuit electrode surface, so that the insulating coating lies in the electrical pathway. However, since the insulating coating of the conductive particles of the invention is only partial, it is possible to satisfactorily reduce the amount of insulating coating lying in the electrical pathway. As a result, the effects of the insulating coating on the pathway can be sufficiently minimized. It is thereby possible to lower the initial resistance value of the connected section compared to using conductive particles whose entire surfaces are covered with an insulating coating, and hence more reliably prevent increase in the resistance value with time.

The crosslinking degree of the organic high molecular compound in the insulating coating of the conductive particles of the invention is preferably 5-20%. A crosslinking degree of 5-20% for the organic high molecular compound will allow excellent insulation to be provided more reliably between adjacent circuit electrodes, while also more reliably achieving a lower resistance value at the connected sections and preventing increase in the resistance value with time.

The insulating coating of the conductive particles of the invention may be composed of a plurality of insulating particles containing an organic high molecular compound, provided on the surfaces of the nucleus particles. In this case, the ratio ($D_2/D_1$) of the particle size ($D_2$) of the insulating particles and the particle size ($D_1$) of the nucleus particles is preferably no greater than 1/10. If the ratio is below 1/10, it will be possible to more reliably achieve a lower resistance value at the connected sections and prevent increase in the resistance value with time.

The insulating coating of the conductive particles of the invention may also be composed of an insulating layer containing an organic high molecular compound, provided on the surfaces of the nucleus particles. In this case, the ratio ($T_2/D_1$) of the insulating layer thickness ($T_2$) and the particle size ($D_1$) of the nucleus particles is preferably no greater than 1/10. If the ratio is below 1/10, it will be possible to more reliably achieve a lower resistance value at the connected sections and prevent increase in the resistance value with time.

The adhesive composition of the invention comprises an adhesive component with an adhesive property, wherein the aforementioned conductive particles according to the invention dispersed in the adhesive component. Since the adhesive composition of the invention comprises the aforementioned conductive particles, it can provide both a sufficiently low initial resistance value at connected sections and excellent insulation between adjacent circuit electrodes, while also adequately inhibiting increase in the resistance value of the connected sections, even when the circuit electrodes to be connected are of a fine size.

A circuit-connecting material of the invention is composed of the aforementioned adhesive composition according to the invention, and it is used for bonding between circuit members as well as for electrical connection between the circuit electrodes of the circuit members.

A connection structure of the invention comprises a pair of mutually opposing circuit members, and connected sections that are composed of the aforementioned cured circuit-connecting material according to the invention and lie between the opposing circuit members to bond the circuit members together so that the respective circuit electrodes of the circuit members are electrically connected together.

At least one of the pair of circuit members in the connection structure of the invention may be an IC chip. In the connection structure described above, at least one surface of the circuit electrodes of the pair of circuit members may be composed of at least one metal selected from among gold, silver, tin, ruthenium, rhodium, palladium, osmium, iridium, platinum and indium tin oxide.

Also, the contacting side of at least one of the pair of circuit members contacting the connected section in the connection structure of the invention may include a section composed of at least one material selected from among silicon nitride, silicone compounds and polyimide resins.

According to the circuit member connecting method of the invention, the aforementioned circuit-connecting material of the invention is situated between a pair of mutually opposing circuit members and the assembly is heated and pressed, to form connected sections which are composed of the cured circuit-connecting material and lie between the pair of circuit members, bonding the circuit members together so that the respective circuit electrodes of the circuit members are electrically connected together, thus obtaining a connection structure comprising the pair of circuit members and connected sections.

**Effect of the Invention**

According to the invention it is possible to provide conductive particles that can exhibit a sufficiently low initial resistance value at connected sections and excellent insulation between adjacent circuit electrodes, when circuit members comprising fine-sized circuit electrodes are connected together, and that adequately inhibit increase in the resistance value at the connected sections with time, as well as an adhesive composition and a circuit-connecting material employing the foregoing. It is also possible to provide a connection structure in which circuit members are connected using the aforementioned circuit-connecting material, and a circuit member connecting method by which the structure can be obtained.

**Brief Description of the Drawings**

Fig. 1 is a cross-sectional view showing connected circuit electrodes wherein a circuit-connecting material comprising conductive particles according to the invention is used between the circuit electrodes.
Fig. 2 is a cross-sectional view showing an embodiment of a circuit-connecting material according to the invention.
Fig. 3 is a cross-sectional view showing an embodiment of conductive particles according to the invention.
Fig. 4 is a cross-sectional view showing another embodiment of conductive particles according to the invention.
Fig. 5 is a cross-sectional view showing a circuit-connecting material according to the invention provided on a support.
Fig. 6 is a process drawing in a simplified cross-sectional view showing an embodiment of a circuit member connecting method according to the invention.
Fig. 7 is a cross-sectional view showing a circuit-connecting material according to the invention supported on a support.

**Explanations of Numerals**

1: Nucleus particle, 1a: base material particle, 1b: conductive layer, 2A: insulating particles (insulating coating), 2B: insulating layer (insulating coating), 10A, 10B: conductive particles, 20: adhesive component, 30: first circuit member, 31: circuit board (first circuit board), 32: circuit electrode (first circuit electrode), 40: second circuit member, 41: circuit board (second circuit board), 42: circuit electrode (second circuit electrode), 50, 70: circuit-connecting materials, 60, 60a, 60b: supports, 70a: conductive particle-containing layer, 70b: conductive particle-free layer, 100: connection structure.

**Best Modes for Carrying Out the Invention**

Preferred embodiments of the invention will now be explained in detail, with reference to the accompanying drawings. Throughout the explanation of the drawings, corresponding elements will be referred to by like reference numerals and will be explained only once. For convenience of illustration, the dimensional proportions in the drawings may not match those explained in the text.
The term "(meth)acrylic acid" used in the present specification refers to "acrylic acid" and its corresponding "methacrylic acid", while "(meth)acrylate" refers to "acrylate" and its corresponding "methacrylate".

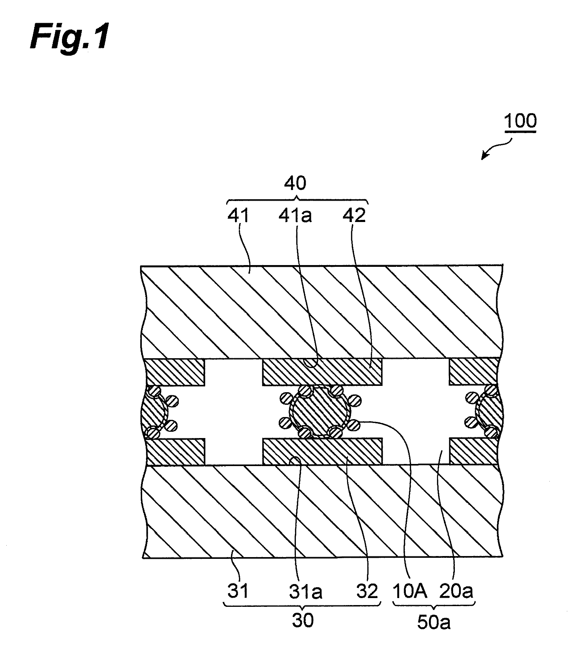

Fig. 1 is a simplified cross-sectional view showing a connection structure with connected circuit electrodes, wherein an adhesive composition comprising conductive particles according to the invention is used as the circuit-connecting material. The connection structure 100 shown in Fig. 1 comprises a first circuit member 30 and a second circuit member 40 which are mutually opposing, and a circuit-connecting member 50a which is formed between the first circuit member 30 and second circuit member 40 and connects them.
The first circuit member 30 comprises a circuit board (first circuit board) 31, and a circuit electrode (first circuit electrode) 32 formed on the main side 31 a of the circuit board 31. The second circuit member 40 comprises a circuit board (second circuit board) 41, and a circuit electrode (second circuit electrode) 42 formed on the main side 41a of the circuit board 41. The surfaces of the circuit electrodes 32, 42 on the circuit boards 31,41 are flat. The phrase "the surfaces of the circuit electrodes ... are flat" means that the sizes of the irregularities on the surfaces of the circuit electrodes are no greater than 20 nm.
As specific examples of circuit members there may be mentioned chip parts such as IC chips (semiconductor chips), resistor chips and condenser chips. These circuit members have circuit electrodes, and ordinarily have multiple circuit electrodes. As specific examples of other circuit members to which these circuit members are connected, there may be mentioned circuit boards, including flexible tapes or flexible printed circuit boards with metal wirings, and glass substrates vapor deposited with indium tin oxide (ITO). According to the invention, such circuit members can be efficiently connected with high connection reliability. The conductive particles of the invention, therefore, are suitable for COG mounting or COF mounting of chip parts with numerous microterminals (circuit electrodes) onto circuit boards.

The main side 31a and/or main side 41a may be coated with silicon nitride, silicone compound or a silicone resin, or with an organic insulating material such as a photosensitive or non-photosensitive polyimide resin. The main side 31a and/or main side 41a may also have partial regions of such materials. The circuit board 31 and/or circuit board 41 itself may also be composed of such materials. The main sides 31 a, 41 a may be composed of one type or two or more types of the aforementioned materials. Appropriate selection of the adhesive component will allow satisfactory connection between circuit boards having sections composed of the aforementioned materials.

The surface of each of the circuit electrodes 32, 42 may be composed of one metal, or two or more metals, selected from among gold, silver, tin, ruthenium, rhodium, palladium, osmium, iridium, platinum and indium tin oxide (ITO). The materials for the surfaces of the circuit electrodes 32, 42 may be the same or different for all of the circuit electrodes.

The connected section 50a comprises the cured product 20a of the adhesive component in the circuit-connecting material, and conductive particles 10A dispersed therein. In the connection structure 100, the opposing circuit electrode 32 and circuit electrode 42 are electrically connected via the conductive particles 10A. That is, the conductive particles 10A directly connect the circuit electrodes 32, 42.

This adequately reduces the connection resistance between the circuit electrodes 32, 42, allowing satisfactory electrical connection to be established between the circuit electrodes 32, 42. The cured product 20a, on the other hand, is electrically insulating, and therefore insulation is ensured between adjacent circuit electrodes. Consequently, smooth current flow can be achieved between the first and second circuit electrodes 32, 42, to allow the function of the circuit to be adequately exhibited.

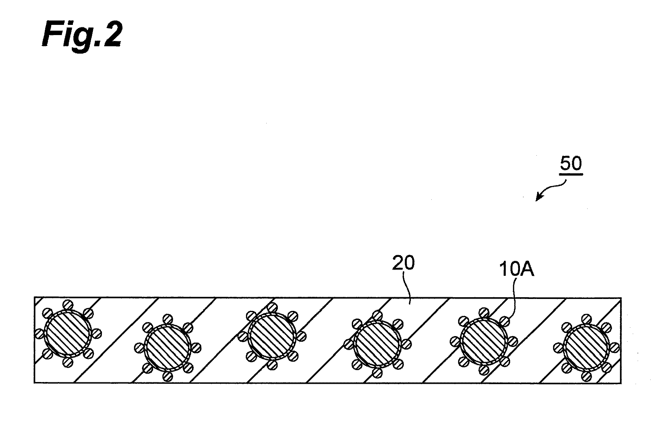

The adhesive composition in its state prior to curing of the adhesive component will now be explained in detail. Fig. 2 is a simplified cross-sectional view showing a preferred embodiment of an adhesive composition according to the invention, used as a circuit-connecting material. The circuit-connecting material 50 in Fig. 2 is in the form of a sheet. The circuit-connecting material 50 comprises an adhesive component 20 and conductive particles 10A dispersed in the adhesive component 20. The adhesive composition may be in the form of a paste, but when used for COG mounting or COF mounting of an IC chip or the like, the circuit-connecting material is preferably formed into a sheet from the viewpoint of workability.

The circuit-connecting material 50 is produced by using a coating apparatus to coat an adhesive composition containing an adhesive component and conductive particles onto a support film, and drying it with hot air for a prescribed period of time.

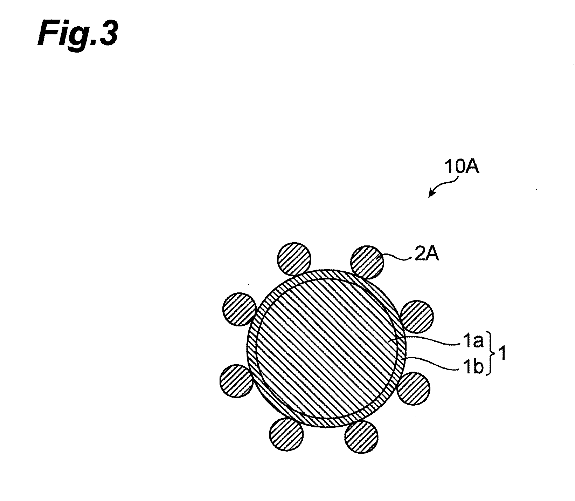

The construction of the conductive particles 10A will now be explained with reference to Fig. 3. Fig. 3 is a cross-sectional view showing a preferred embodiment of conductive particles according to the invention. The conductive particles 10A shown in Fig. 3 are each composed of a conductive nucleus particle 1 and multiple insulating particles 2A on the surface of the nucleus particle 1.

The nucleus particle 1 is composed of a base material particle 1a constituting the center section, and a conductive layer 1b formed on the surface of the base material particle 1a.

The material of the base material particle 1a may be glass, ceramic, an organic high molecular compound or the like. Preferred among these materials are ones that deform by heat and/or pressure (for example, glass and organic high molecular compounds). If the base material particle 1a deforms, the contact area with the circuit electrode will increase when the conductive particles 10A are pressed by the circuit electrodes 32, 42. This will also absorb irregularities on the surfaces of the circuit electrodes 32, 42. The connection reliability between the circuit electrodes will therefore be improved.

From this viewpoint, examples of preferred materials for the base material particle 1a are acrylic resins, styrene resins, benzoguanamine resins, silicone resins, polybutadiene resins, and their copolymers, as well as their crosslinked forms. The base material particles 1a may be made of the same material or different materials for different particles, and each particle may be composed of one material or a combination of two or more materials.

The mean particle size of the base material particles 1a may be appropriately designed according to the purpose of use, but it is preferably 0.5-20 $\mu$m, more preferably 1-10 $\mu$m and even more preferably 2-5 $\mu$m. If the conductive particles are produced using base material particles with a mean particle size of less than 0.5 $\mu$m, secondary aggregation of the particles will occur, tending to result in an insufficient insulating property between adjacent circuit electrodes, while if the conductive particles are formed using base material particles larger than 20 $\mu$m, the insulating property between adjacent circuit electrodes will tend to be inadequate due to their size.

The conductive layer 1b is a layer composed of a conductive material formed covering the surfaces of the base material particles 1a. From the viewpoint of satisfactorily ensuring conductivity, the conductive layer 1b preferably covers the entirety of the base material particles 1a.

The material of the conductive layer 1b may be, for example, gold, silver, platinum, nickel or copper, an alloy of these, a tin-containing alloy such as solder, or a conductive non-metal such as carbon. Since the base material particles 1a can be covered by electroless plating, the material of the conductive layer 1b is preferably a metal. In order to achieve a sufficient pot life, gold, silver or platinum, or an alloy thereof, is preferred, with gold being more preferred. Any of these may be used alone or in combinations of two or more.

The thickness of the conductive layer 1b may be appropriately designed according to the material and purpose of use, but it is preferably 50-200 nm and more preferably 80-150 nm. If the thickness is less than 50 nm, it may not be possible to obtain a sufficiently low resistance value at the connected sections. On the other hand, a conductive layer 1b with a thickness of greater than 200 nm will tend to lower the production efficiency.

The conductive layer 1b may consist of a single layer or two or more layers. In either case, the surface layer of the nucleus particle 1 is preferably composed of gold, silver, platinum or an alloy thereof, and more preferably gold, from the viewpoint of the storage life of the adhesive composition produced using it. When the conductive layer 1b consists of a single layer composed of gold, silver, platinum or an alloy thereof (hereinafter referred to as "gold or other metal"), the thickness is preferably 10-200 nm in order to obtain a sufficiently low resistance value at the connected sections.

When the conductive layer 1b consists of two or more layers, on the other hand, the outermost layer of the conductive layer 1b is preferably composed of gold or other metal, but the layer between the outermost layer and the base material particle 1a may be composed of a metal layer containing nickel, copper, tin or an alloy thereof In this case, the thickness of the metal layer composed of gold or other metal which forms the outermost layer of the conductive layer 1b is preferably 30-200 nm from the viewpoint of the storage life of the adhesive composition. The nickel, copper, tin or alloy thereof can generate free radicals by oxidation-reduction. Therefore, when the thickness of the outermost layer composed of the gold or other metal is less than 30 nm, it will tend to be difficult to adequately prevent the effects of free radicals when used with a radical-polymerizing adhesive component.

The method for forming the conductive layer 1b on the base material particle 1a surface may be electroless plating treatment or physical coating treatment. From the viewpoint of ease of forming the conductive layer 1b, the conductive layer 1b composed of metal is preferably formed on the surface of the base material particle 1a by electroless plating treatment.

The insulating particles 2A are composed of an organic high molecular compound. The organic high molecular compound is preferably thermosoftening. Examples of preferred materials for the insulating particles include polyethylene, ethylene-acetic acid copolymers, ethylene-(meth)acrylic copolymers, ethylene-(meth)acrylic acid copolymers, ethylene-(meth)acrylic acid ester copolymers, polyesters, polyamides, polyurethanes, polystyrenes, styrene-divinylbenzene copolymers, styrene-isobutylene copolymers, styrene-butadiene copolymers, styrene-(meth)acryl copolymers, ethylene-propylene copolymers, (meth)acrylic acid ester-based rubbers, styrene-ethylene-butylene copolymers, phenoxy resins and solid epoxy resins. These may be used alone or in combinations of two or more. From the viewpoint of particle size distribution dispersity, solvent resistance and heat resistance, styrene-(meth)acryl copolymers are particularly preferred. The process for production of the insulating particles 2A may be a seed polymerization process.

The softening point of the organic high molecular compound composing the insulating particles 2A is preferably above the heating temperature during connection of the circuit members. If the softening point is below the heating temperature during connection, it may not be possible to obtain satisfactory electrical connection due to excessive deformation of the insulating particles 2A during connection.

The crosslinking degree of the organic high molecular compound composing the insulating particles 2A is preferably 5-20%, more preferably 5-15% and even more preferably 8-13%. An organic high molecular compound with a crosslinking degree within this range is superior in terms of both connection reliability and insulation properties, compared to an organic high molecular compound outside of the range. Therefore, a crosslinking degree of less than 5% will tend to result in insufficient insulation between adjacent electrode circuits. On the other hand, a crosslinking degree of greater than 20% will tend to hamper efforts to achieve both an adequately low initial resistance value and prevent a gradually increasing resistance value at the connected sections.

The crosslinking degree of the organic high molecular compound can be adjusted by the compositional ratio between the crosslinkable monomers and non-crosslinkable monomers. The crosslinking degree, according to the invention, is the theoretical value calculated from the compositional ratio (charging weight ratio) between crosslinkable monomer and non-crosslinkable monomer. Specifically, it is the value calculated by dividing the charging weight of crosslinkable monomer added for synthesis of the organic high molecular compound, by the total charging weight ratio of crosslinkable and non-crosslinkable monomer.

The gel fraction of the organic high molecular compound composing the insulating particles 2A is preferably at least 90% and more preferably at least 95%. If the gel fraction is less than 90%, the insulation resistance of the adhesive component will tend to decrease with time when the conductive particles 10A are dispersed in the adhesive component to form an adhesive composition.

The gel fraction referred to here is an index of the resistance of the organic high molecular compound to solvents, and it is measured in the following manner. The weight of the organic high molecular compound whose gel fraction is to be determined (the measuring sample) (weight A) is measured. The measuring sample is placed in a container and the solvent is added. The measuring sample is stirred for 24 hours while immersed in the solvent at a temperature of 23°C. Next, the solvent is removed by volatilization or the like, and the weight of the stirred and immersed measuring sample (weight B) is measured. The gel fraction (%) is the value calculated by the formula: (weight B/weight A $\times$ 100).

The solvent used for measurement of the gel fraction is toluene. Generally, a solvent such as toluene, xylene, ethyl acetate, butyl acetate, methyl ethyl ketone, methyl isobutyl ketone or tetrahydrofuran will be used to prepare the solution of the adhesive composition. Any one of these solvents may be used alone, or two or more thereof may be used in admixture.

The mean particle size of the insulating particles 2A may be appropriately designed according to the purpose of use, but it is preferably 50-500 nm, more preferably 50-400 nm and even more preferably 100-300 nm. If the mean particle size is less than 50 nm the insulation between adjacent circuits will tend to be insufficient, while if it is greater than 500 nm, it will tend to be difficult to achieve both an adequately low initial resistance value and prevent a gradually increasing resistance value at the connected sections.

The insulating particles 2A are formed on the surface of the nucleus particles 1 to a coverage factor of 20-40%, as defmed by formula (1) above. From the standpoint of obtaining an even more reliable effect according to the invention, the coverage factor is preferably 25-35% and more preferably 28-32%. If the coverage factor is less than 20% the insulation between adjacent circuit electrodes will tend to be insufficient, while if it is greater than 40%, it will tend to be difficult to achieve both an adequately low initial resistance value and prevent a gradually increasing resistance value at the connected sections. The multiple insulating particles 2A covering each nucleus particle 1 are preferably thoroughly dispersed on the surface of the nucleus particle 1.

The coverage factor, according to the invention, is based on the following measured value, obtained by observation with a differential scanning electron microscope (magnification: 8000x). Specifically, the coverage factor is the value calculated based on the particle sizes of the nucleus particles and insulating particles and the number of insulating particles attached to one nucleus particle. Measurement is made in this manner for 50 arbitrarily selected particles and the average value is calculated.

The particle sizes of the nucleus particles 1 are measured in the following manner. Specifically, one nucleus particle is arbitrarily selected and observed with a differential scanning electron microscope to measure its maximum diameter and minimum diameter. The square root of the product of the maximum diameter and minimum diameter is recorded as the particle size of the particle. The particle sizes are measured in this manner for 50 arbitrarily selected nucleus particles and the average value is recorded as the particle size ($D_1$) of the nucleus particles 1. The particle sizes of the insulating particles 2A are determined in a similar fashion, by measuring the particle sizes of any 50 insulating particles and recording the average value as the particle size ($D_2$) of the insulating particles 2A.

The number of insulating particles on one conductive particle is measured in the following manner. Specifically, one conductive particle whose surface is partially covered with multiple insulating particles 2A is arbitrarily selected. It is imaged with a differential scanning electron microscope, and the number of insulating particles adhering onto the observable nucleus particle surface are counted. The obtained count is doubled to calculate the number of insulating particles adhering to one nucleus particle. The number of insulating particles is determined in this manner for 50 arbitrarily selected conductive particles, and the average value is recorded as the number of insulating particles on one conductive particle.

The total surface area of the nucleus particle in formula (1) is the surface area of a sphere having diameter $D_1$. The area of the portion of the nucleus particle surface covered by the insulating coating is the value obtained by multiplying the value of the area enclosed by a circle with diameter $D_2$ by the number of insulating particles on one conductive particle.

The ratio ($D_2/D_1$) of the mean particle size $D_2$ of the insulating particles 2A and the mean particle size $D_1$ of the nucleus particles 1 is preferably no greater than 1/10 and more preferably no greater than 1/15. The lower limit for the ratio ($D_2/D_1$) is preferably 1/20. A $D_2/D_1$ ratio of greater than 1/10 will tend to hamper efforts to achieve both an adequately low initial resistance value and prevent a gradually increasing resistance value at the connected sections. On the other hand, a ratio of less than 1/20 will tend to result in insufficient insulation between adjacent circuits.

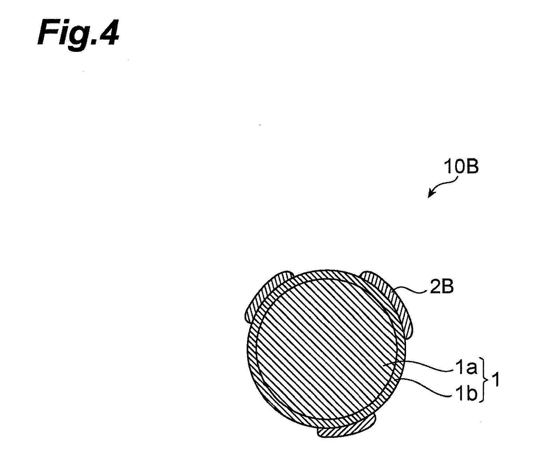

The insulating coating formed on the surface of the nucleus particles 1 is not limited to spheres such as the insulating particles 2A. The insulating coating may also be an insulating layer composed of the same material as the insulating particles 2A. For example, the conductive particles 10B shown in Fig. 4 are provided with an insulating layer 2B partially formed on the surfaces of the nucleus particles 1.

The insulating layer 2B is formed on the surface of the nucleus particles 1 to a coverage factor of 20-40%, as defined by formula (1) above. From the standpoint of obtaining an even more reliable effect according to the invention, the coverage factor is preferably 25-35% and more preferably 28-32%. If the coverage factor is less than 20% the insulation between adjacent circuit electrodes will tend to be insufficient, while if it is greater than 40%, it will tend to be difficult to achieve both an adequately low initial resistance value and prevent a gradually increasing resistance value at the connected sections. The covering regions of the insulating layer 2B covering the nucleus particle 1 are preferably thoroughly dispersed on the surface of the nucleus particle 1. The covering regions may be isolated or continuous.

The ratio ($T_2/D_1$) of the thickness $T_2$ of the insulating layer 2B and the mean particle size $D_1$ of the nucleus particles 1 is preferably no greater than 1/10 and more preferably no greater than 1/15. The lower limit for the ratio ($T_2/D_1$) is preferably 1/20. A $T_2/D_1$ ratio of greater than 1/10 will tend to hamper efforts to achieve both an adequately low initial resistance value and prevent a gradually increasing resistance value at the connected sections. On the other hand, a ratio of less than 1/20 will tend to result in insufficient insulation between adjacent circuits.

When the insulating coating is composed of an insulating layer 2B, the coverage factor may be calculated by the following procedure. Specifically, 50 arbitrarily selected conductive particles may be imaged with a differential scanning electron microscope, and the arithmetic mean calculated for the measured values of the area of the insulating layer adhering to the observable nucleus particle surface. The thickness $T_2$ of the insulating layer 2B may also be determined by imaging 50 arbitrarily selected conductive particles with a differential scanning electron microscope, and calculating the arithmetic mean for the measured values of the thickness of the insulating layer 2B on the surface of each conductive particle.

The method for forming the insulating coating (the insulating particles 2A or insulating layer 2B) on the surfaces of the nucleus particles 1 may be any known method, and there may be mentioned wet methods utilizing chemical changes produced by organic solvents or dispersing agents, and dry methods utilizing physicochemical changes produced by mechanical energy. Spraying, whipping and spray drier methods may be mentioned as examples of such methods.

In order to more reliably obtain the effect of the invention, preferably multiple insulating particles 2A, having a sufficiently uniform particle size, are provided on the surface of each nucleus particle 1 to form the insulating coating. Also, a dry system using no solvent is preferred over a wet system because of the difficulty of completely removing the solvent or dispersing agent.

As examples of apparatuses to be used to form the insulating coating over the surfaces of the nucleus particles 1 in a dry system there may be mentioned Mechanomill (trade name of Tokuju Co., Ltd.) and hybridizers (NHS Series, trade name of Nara Machinery Co., Ltd.). Of these, it is preferred to use a hybridizer since it will allow the surfaces of the nucleus particles 1 to be modified to a desirable state when the insulating coating is formed on the surfaces of the nucleus particles 1. Such an apparatus can achieve precise covering on the particle level, and allows insulating particles 2A with a sufficiently uniform particle size to be formed on the surfaces of the nucleus particles 1.

The form of the insulating coating can be controlled by adjusting the conditions of the coating treatment, for example. The conditions for the coating treatment include, for example, the temperature and rotational speed. The particle size of the insulating particles 2A and the thickness of the insulating layer 2B can be modified by adjusting the coating treatment conditions or the mixing ratio of the nucleus particles 1 and organic high molecular compound (insulating coating material) supplied for the treatment.

The (dry) coating treatment temperature is preferably 30-90°C and more preferably 50-70°C. The rotational speed for (dry) coating treatment is preferably 6000-20000/min and more preferably 10000-17000/min.

The adhesive component in which the conductive particles are dispersed will now be explained. The adhesive component 20 is preferably a composition comprising an adhesive composed of (a) a thermosetting resin and (b) a thermosetting resin-curing agent, a composition comprising an adhesive composed of (c) a curing agent that generates free radical by heat or light and (d) a radical-polymerizing substance, or a mixed composition comprising (a), (b), (c) and (d).

The adhesive component may be a thermoplastic resin such as polyethylene or polypropylene. From the viewpoint of heat resistance, humidity resistance and mechanical properties, it is preferably a curable resin such as an epoxy resin, polyimide resin, polyamideimide resin or acrylic resin. The adhesive component will now be explained in detail.

The (a) thermosetting resin is not particularly restricted so long as it is a thermosetting resin that is capable of curing in the desired temperature range, but epoxy resins are preferred. As epoxy resins there may be mentioned bisphenol A-type epoxy resins, bisphenol F-type epoxy resins, bisphenol S-type epoxy resins, phenol/novolac-type epoxy resins, cresol/novolac-type epoxy resins, bisphenol A/novolac-type epoxy resins, bisphenol F/novolac-type epoxy resins, alicyclic epoxy resins, glycidyl ester-type epoxy resins, glycidylamine-type epoxy resins, hydantoin-type epoxy resins, isocyanurate-type epoxy resins and aliphatic linear epoxy resins. These epoxy resins may be halogenated or hydrogenated. The aforementioned epoxy resins may also be used alone or in combinations of two or more.

As the (b) thermosetting resin-curing agent there may be mentioned amine-based, phenol-based, acid anhydride-based, imidazole-based and hydrazide-based curing agents, dicyandiamides, boron trifluoride-amine complexes, sulfonium salts, iodonium salts, amineimides and the like. They may also be used alone or in combinations of two or more, and may also be used in admixture with triggers or inhibitors. From the viewpoint of extending the working life, these curing agents are preferably used in a microcapsulated form by coating with a polyurethane-based or polyester-based macromolecular compound.

The content of the (b) thermosetting resin-curing agent is preferably about 0.1-60.0 wt% and more preferably 1.0-20.0 wt% based on the total weight of the adhesive component. If the content of the thermosetting resin-curing agent is less than 0.1 wt%, the curing reaction will not proceed sufficiently and it will tend to be difficult to obtain satisfactory adhesive strength and connection resistance. If it exceeds 60 wt%, on the other hand, the flow property of the adhesive component will be reduced and the pot life will tend to be shorter. The connection resistance at the connected sections will also tend to be increased.

The (c) curing agent which generates free radicals by heat or light may be one that generates free radicals upon decomposition by heat or light, such as a peroxide compound or azo-based compound. These may be appropriately selected as appropriate for the desired connection temperature, connection time and pot life. From the standpoint of achieving both high reactivity and a long pot life, an organic peroxide used preferably has a 10 hour half-life temperature of 40°C or higher and a 1 minute half-life temperature of no higher than 180°C. In this case, the content of the (c) curing agent which generates free radicals by heat or light is preferably 0.05-10 wt% and more preferably 0.1-5 wt%, based on the total weight of the adhesive component.

Specifically, the (c) curing agent which generates free radicals by heat or light may be selected from among diacyl peroxides, peroxy dicarbonates, peroxy esters, peroxy ketals, dialkyl peroxides, hydroperoxides and the like. In order to minimize corrosion of the circuit electrodes on the circuit members it is preferred to select a peroxy ester, dialkyl peroxide or hydroperoxide, and more preferably to select a peroxy ester which exhibits high reactivity.

As examples of diacyl peroxides there may be mentioned isobutyl peroxide, 2,4-dichlorobenzoyl peroxide, 3,5,5-trimethylhexanoyl peroxide, octanoyl peroxide, lauroyl peroxide, stearoyl peroxide, succinic peroxide, benzoylperoxytoluene and benzoyl peroxide.

As examples of peroxy dicarbonates there may be mentioned di-n-propylperoxy dicarbonate, diisopropylperoxy dicarbonate, bis(4-t-butylcyclohexyl)peroxy dicarbonate, di-2-ethoxymethoxyperoxy dicarbonate, di(2-ethylhexylperoxy) dicarbonate, dimethoxybutylperoxy dicarbonate and di(3-methyl-3-methoxybutylperoxy)dicarbonate.

As examples of peroxy esters there may be mentioned cumylperoxy neodecanoate, 1,1,3,3-tetramethylbutylperoxy neodecanoate, 1-cyclohexyl-1-methylethylperoxy neodecanoate, t-hexylperoxy neodecanoate, t-butylperoxy pivalate, 1,1,3,3-tetramethylbutylperoxy-2-ethyl hexanoate, 2,5-dimethyl-2,5-bis(2-ethylhexanoyl peroxy)hexane, 1-cyclohexyl-1-methylethylperoxy-2-ethyl hexanoate, t-hexylperoxy-2-ethyl hexanoate, t-butylperoxy-2-ethyl hexanoate, t-butylperoxy isobutyrate, 1,1-bis(t-butylperoxy)cyclohexane, t-hexylperoxyisopropyl monocarbonate, t-butylperoxy-3,5,5-trimethyl hexanoate, t-butylperoxy laurate, 2,5-dimethyl-2,5-bis(m-toluoylperoxy)hexane, t-butylperoxyisopropyl monocarbonate, t-butylperoxy-2-ethylhexyl monocarbonate, t-hexylperoxy benzoate and t-butylperoxy acetate.

As examples of peroxy ketals there may be mentioned 1,1-bis(t-hexylperoxy)-3,5,5-trimethylcyclohexane, 1,1-bis(t-hexylperoxy)cyclohexane, 1.1-bis(t-butylperoxy)-3,5,5-trimethylcyclohexane, 1,1-(t-butylperoxy)cyclododecane and 2,2-bis(t-butylperoxy)decane.

As examples of dialkyl peroxides there may be mentioned $\alpha,\alpha'$-bis(t-butylperoxy)diisopropylbenzene, dicumyl peroxide, 2,5-dimethyl-2,5-di(t-butylperoxy)hexane and t-butylcumyl peroxide.

As examples of hydroperoxides there may be mentioned diisopropylbenzene hydroperoxide and cumene hydroperoxide.

These (c) curing agents that generate free radicals by heat or light may be used alone or in combinations of two or more, and may also be used in admixture with triggers or inhibitors.

The (d) radical-polymerizing substance has a functional group that polymerizes by active radicals, and (meth) acrylate and maleimide compounds may be mentioned as examples.

As examples of (meth)acrylates there may be mentioned urethane (meth)acrylate, methyl (meth)acrylate, ethyl (meth)acrylate, isopropyl (meth)acrylate, isobutyl (meth)acrylate, ethyleneglycol di(meth)acrylate, diethyleneglycol di (meth)acrylate, triethyleneglycol di(meth)acrylate, trimethylolpropane tri(meth)acrylate, tetramethylolmethane tetra (meth)acrylate, 2-hydroxy-1,3-di(meth)acryloxypropane, 2,2-bis[4-((meth)acryloxymethoxy)phenyl]propane, 2,2-bis [4-((meth)acryloxypolyethoxy)phenyl]propane, dicyclopentenyl (meth)acrylate, tricyclodecanyl (meth)acrylate, bis((meth)acryloxyethyl) isocyanurate, $\varepsilon$-caprolactone-modified tris((meth)acryloxyethyl) isocyanurate and tris((meth) acryloxyethyl) isocyanurate.

Any of these radical-polymerizing substances may be used alone or in combinations of two or more. The adhesive component most preferably contains at least a radical-polymerizing substance with a 25°C viscosity of 100000-1000000 mPa·s, and even more preferably contains a radical-polymerizing substance with a viscosity (25°C) of 100000-500000 mPa·s. The viscosity of the radical-polymerizing substance may be measured using a commercially available Brookfield viscometer.

Urethane (meth)acrylate is preferred among radical-polymerizing substances from the viewpoint of adhesion, and most preferably it is used in combination with a radical-polymerizing substance that exhibits a Tg of 100°C or higher alone, after crosslinking with an organic peroxide used to improve the heat resistance. As such radical-polymerizing substances there may be used substances having dicyclopentenyl, tricyclodecanyl and/or triazine rings in the molecule.

Particularly preferred for use are radical-polymerizing substances with tricyclodecanyl and/or triazine ring groups in the molecule.

Preferred maleimide compounds are those with two or more maleimide groups in the molecule, and as examples there may be mentioned 1-methyl-2,4-bismaleimidebenzene, N,N'-m-phenylenebismaleimide, N,N'-p-phenylenebismaleimide, N,N'-m-toluilenebismaleimide, N,N'-4,4-biphenylenebismaleimide, N,N'-4,4-(3,3'-dimethyl-biphenylene) bismaleimide, N,N'-4,4-(3,3'-dimethyldiphenylmethane)bismaleimide, N,N'-4,4-(3,3'-diethyldiphenylmethane)bismaleimide, N,N'-4,4-diphenylmethanebismaleimide, N,N'-4,4-diphenylpropanebismaleimide, N,N'-4,4-diphenyletherbismaleimide, N,N'-3,3'-diphenylsulfonebismaleimide, 2,2-bis[4-(4-maleimidephenoxy)phenyl]propane, 2,2-bis[3-s-butyl-4,8-(4-maleimidephenoxy)phenyl]propane, 1, 1-bis[4-(4-maleimidephenoxy)phenyl]decane, 4,4'-cyclohexylidene-bis[1-{4-maleimidephenoxy)-2-cyclohexyl]benzen e, 2,2-bis[4-(4-maleimidephenoxy)phenyl]hexafluoropropane and the like. These may be used alone or in combinations of two or more, and may also be used together with allyl compounds such as allylphenol, allylphenyl ether and allyl benzoate.

If necessary, an appropriate amount of a polymerization inhibitor such as hydroquinone or methyl ether hydroquinone may be used.

The adhesive component 20 may also contain a film-forming polymer. The content of the film-forming polymer is preferably 2-80 wt%, more preferably 5-70 wt% and even more preferably 10-60 wt% based on the total weight of the adhesive component 20. As film-forming polymers there may be mentioned polystyrene, polyethylene, polyvinyl butyral, polyvinyl formal, polyimides, polyamides, polyesters, polyvinyl chloride, polyphenylene oxide, urea resins, melamine resins, phenol resins, xylene resins, polyisocyanate resins, phenoxy resins, polyimide resins, polyester-urethane resins and the like.

Of these film-forming polymers, resins with functional groups such as hydroxyl are preferred since they can improve the adhesion. Such polymers that have been modified with radical-polymerizing functional groups may also be used.

The circuit-connecting material 50 may also contain a filler, softening agent, accelerator, age inhibitor, coloring agent, flame retardant, thixotropic agent, coupling agent, phenol resin, melamine resin, isocyanate or the like.

A filler is preferably included to improve the connection reliability. The filler used may be any one with a maximum diameter of less than the particle size of the conductive particles, and it is preferably used in a range of 5-60 vol%. The effect of improved reliability becomes saturated at greater than 60 vol%.

Preferred coupling agents, from the viewpoint of adhesion, are compounds containing one or more groups selected from among vinyl, acrylic, amino, epoxy and isocyanate groups.

The content of the conductive particles 10A in the circuit-connecting material 50 is preferably 0.1-30 parts by volume based on 100 parts by volume as the total volume of the circuit-connecting material 50, and the content may be modified according to the purpose of use. In order to achieve high connection reliability, the content is more preferably 0.1-10 parts by volume.

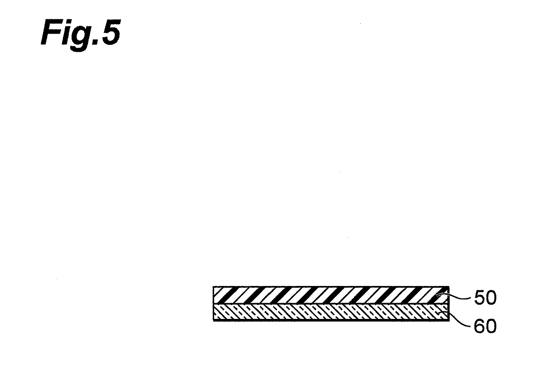

Fig. 5 is a cross-sectional view showing a circuit-connecting material 50 according to the invention provided on a film-like support 60. The support 60 used may be any of various types of films such as, for example, a polyethylene terephthalate film (PET film), polyethylene naphthalate film, polyethylene isophthalate film, polybutylene terephthalate film, polyolefm-based film, polyacetate film, polycarbonate film, polyphenylene sulfide film, polyamide film, ethylene-vinyl acetate copolymer film, polyvinyl chloride film, polyvinylidene chloride film, synthetic rubber-based film, liquid crystal polymer film or the like. The support used may be one wherein the surface of the film has been subjected to corona discharge treatment, anchor coat treatment, antistatic treatment or the like, as necessary.

When using the circuit-connecting material 50, a release treatment agent may be used to coat the surface of the support 60 if necessary in order to allow easier release of the support 60 from the circuit-connecting material 50. As release treatment agents, there may be used various types of release treatment agents such as silicone resins, copolymers of silicone and organic resins, alkyd resins, aminoalkyd resins, resins with long-chain alkyl groups, resins with fluoroalkyl groups, shellac resins and the like.

The film thickness of the support 60 is not particularly restricted, but considering storage of the produced circuit-connecting material 50 and greater convenience of use, it is preferably 4-200 $\mu$m, while from the viewpoint of material cost and productivity it is more preferably 15-75 $\mu$m.

(Connecting method)

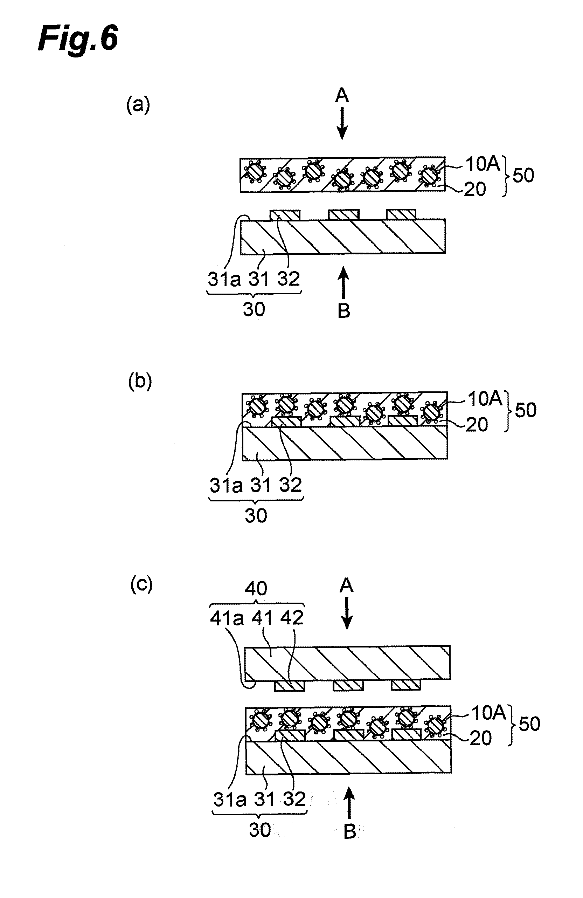

Fig. 6 is a process drawing in a simplified cross-sectional view showing an embodiment of a circuit member connecting method according to the invention. According to this embodiment, the circuit-connecting material is thermoset to fabricate a connection structure.

First, the first circuit member 30 and sheet-like circuit-connecting material 50 are prepared. The circuit-connecting material 50 is composed of an adhesive composition containing the conductive particles 10A.

The thickness of the circuit-connecting material 50 is preferably 5-50 $\mu$m. If the thickness of the circuit-connecting material 50 is less than 5 μm, the circuit-connecting material 50 may fail to sufficiently fill the area between the first and second circuit electrodes 32, 42. If the thickness is greater than 50 μm, on the other hand, it may be difficult to ensure conduction between the first and second circuit electrodes 32, 42.

The circuit-connecting material 50 is then placed over the side of the first circuit member 30 on which the circuit electrode 32 has been formed. The circuit-connecting material 50 is pressed in the direction of the arrows A and B in Fig. 5(a) to provisionally join the circuit-connecting material 50 with the first circuit member 30 (see (Fig. 5(b)).

The pressure used in most cases for this procedure is preferred to be 0.1-30.0 MPa, although it is not particularly restricted so long as it is in a range that does not damage the circuit member. The pressure may be applied while heating, and the heating temperature should be a temperature that essentially does not cause hardening of the circuit-connecting material 50. The heating temperature is usually preferred to be 50-190°C. The heating and pressing are preferably carried out for a period in the range of 0.5-120 seconds.

Next, as shown in Fig. 5(c), the second circuit member 40 is placed on the circuit-connecting material 50 with the second circuit electrode 42 facing the first circuit member 30. The entire sheet-like circuit-connecting material 50 is pressed in the direction of the arrows A and B in Fig. 5(c) while heating.

The heating temperature at this time is a temperature at which the circuit-connecting material 50 can be cured. The heating temperature is preferably in the range of 60-180°C, more preferably in the range of 70-170°C and even more preferably in the range of 80-160°C. If the heating temperature is below 60°C the curing speed will tend to be slowed, and if it is above 180°C there will be a tendency for secondary reactions to occur. The heating time is preferably 0.1-180 seconds, more preferably 0.5-180 seconds and even more preferably 1-180 seconds.

Curing of the circuit-connecting material 50 forms a connected section 50a, to obtain a connection structure 100 as shown in Fig. 1: The conditions for the connection may be appropriately selected depending on the purpose of use, the adhesive composition and the circuit member. When a component that cures by light is used as the adhesive component of the circuit-connecting material 50, the circuit-connecting material 50 may be appropriately irradiated with active light rays or energy rays. As active light rays there may be mentioned ultraviolet rays, visible light and infrared rays. As energy rays there may be mentioned an electron beam, X-rays, γ-rays and microwaves.

The embodiments described above are preferred embodiments of the invention, but the invention is not limited thereto. The invention may also be applied in a variety of other embodiments so long as the gist thereof is maintained. For example, although the nucleus particles 1 are composed of a base material particle 1a and a conductive layer 1b in the embodiment described above, the nucleus particles may instead be composed of a conductive material (for example, the same material as the conductive layer 1b). Particles made of a heat-fusible metal may also be used as the nucleus particles. This will allow the nucleus particles to be sufficiently deformed by heat and pressure.

The conductive particles may have both insulating particles 2A and an insulating layer 2B as the insulating coating on the surface of the nucleus particles 1.

The sheet-like circuit-connecting material may have a monolayer structure or it may have multiple layers as a laminated multilayer structure. The circuit-connecting material in a multilayer structure may be produced by laminating multiple layers with different types of adhesive components and conductive particles or different contents thereof. For example, the circuit-connecting material may be provided with a conductive particle-containing layer containing conductive particles, and a conductive particle-free layer containing no conductive particles, provided on at least one side of the conductive particle-containing layer.

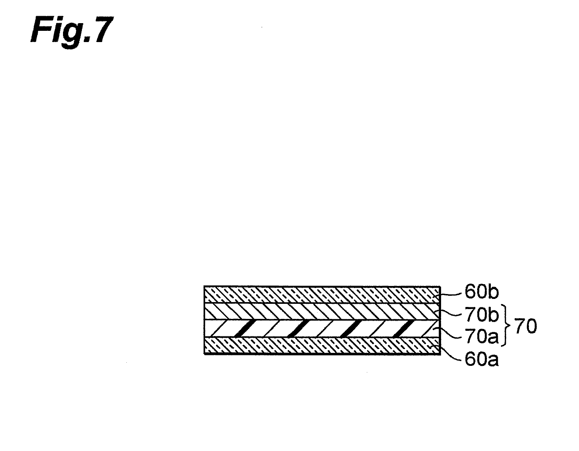

Fig. 7 is a cross-sectional view showing a circuit-connecting material with a bilayer structure supported on a support. The circuit-connecting material 70 shown in Fig. 7 is composed of a conductive particle-containing layer 70a containing conductive particles and a conductive particle-free layer 70b containing no conductive particles. Both outer sides of the circuit-connecting material 70 are provided with respective supports 60a, 60b. The circuit-connecting material 70 may be produced by forming the conductive particle-containing layer 70a on the surface of the support 60a, forming the conductive particle-free layer 70b on the surface of the support 60b, and attaching the layers using a known laminator or the like. The supports 60a, 60b are later released when the circuit-connecting material 70 is used.

With the circuit-connecting material 70, it is possible to adequately prevent reduction in the number of conductive particles on the circuit electrode caused by flow of the adhesive component when the circuit members are bonded together. Therefore, when an IC chip is connected to a board by COG mounting or COF mounting, for example, it is possible to adequately guarantee a number of conductive particles on the metal bumps of the IC chip. In this case, the circuit-connecting material 70 is preferably situated so that contact is established between the side of the IC chip bearing the metal bumps and the conductive particle-free layer 70b, and between the board on which the IC chip is to be mounted and the conductive particle-containing layer 70a.

**Examples**

(Example 1)

Conductive nucleus particles were produced in the following manner. Specifically, crosslinked polystyrene particles were prepared as base material particles (SX Series, trade name of Soken Chemical & Engineering Co., Ltd., mean particle size: 4 $\mu$m), and a Ni layer (0.08$\mu$ m thickness) was formed by electroless plating treatment on the surfaces of the particles. Also, an Au layer (0.03 $\mu$m thickness) was formed on the outside of the Ni layer by electroless plating treatment, to obtain nucleus particles having a conductive layer composed of a Ni layer and Au layer.

A crosslinked acrylic resin (MP Series, trade name of Soken Chemical & Engineering Co., Ltd., crosslinking degree: 20%, gel fraction: 18%) was prepared as an organic high molecular compound (insulating coating) to cover the surface of the nucleus particles. There were introduced into a hybridizer (NHS Series, trade name of Nara Machinery Co., Ltd.) 4 g of the crosslinked acrylic resin and 20 g of nucleus particles, and conductive particles were produced. The conditions for the hybridizer were a rotational speed of 16000/min and a reaction tank temperature of 60°C. Conductive particles having the construction shown in Fig. 3 were thus obtained. Observation with a differential scanning electron microscope (magnification: 8000x) revealed that the coverage factor of the conductive particles was 25%.

Next, a bisphenol A-type epoxy resin and 9,9'-bis(4-hydroxyphenyl)fluorene were used to synthesize a phenoxy resin with a glass transition temperature of 80°C. The phenoxy resin (50 g) was dissolved in a solvent to prepare a solution with a solid content of 40 wt%. The solvent used was a mixed solvent of toluene and ethyl acetate (mixing weight ratio =1:1).

The aforementioned solution was combined with an epoxy resin for 40 g (solid content) of the phenoxy resin and 60 g (solid content) of liquid epoxy resin containing a microcapsulated latent curing agent. With 100 parts by volume of the adhesive component solution obtained in this manner there was mixed 5 parts by volume of the conductive particles, and the mixture was stirred and dispersed at a temperature of 23°C to prepare an adhesive composition solution.

The adhesive composition solution was coated by application onto the surface of a PET film (PUREX, trade name of Teijin-DuPont Films, 50 $\mu$m thickness) that had been surface treated with a release treatment agent (silicone resin). The coated solution was then dried with hot air (5 minutes at 80°C) to obtain a 10 $\mu$m-thick conductive particle-containing layer supported on the PET film.

Also, an adhesive component solution prepared in the same manner was coated by application onto a PET film instead of the adhesive composition solution. The coated solution was then dried with hot air (5 minutes at 80°C) to obtain a 10 $\mu$m-thick conductive particle-free layer supported on the PET film.

The adhesive films were attached together using a conventional laminator. A circuit-connecting material with a bilayer construction as shown in Fig. 7 was thus obtained.

(Fabrication of connection structure)

A circuit-connecting material produced in the manner described above was used to connect an IC chip to an ITO substrate (surface resistance = <20 $\Omega$/ sq.), to form a connection structure. The IC chip used had an area of 2500 $\mu$m$^2$ (50 $\mu$m $\times$ 50 $\mu$m), and gold bumps with a pitch of 100 $\mu$m and a height of 20 $\mu$m. The ITO substrate used was a glass plate with a thickness of 1.1 mm, having ITO vapor deposited on the surface.

A circuit-connecting material was situated between the IC chip and ITO substrate, and a contact bonding apparatus (FC-1200, trade name of Toray Engineering) was used to establish connection. Specifically, first the PET film on the conductive particle-containing layer side was released, and the circuit-connecting material was placed on the ITO substrate with the conductive particle-containing layer in contact with the ITO substrate. A contact bonding apparatus was used for temporary contact bonding (2 seconds at a temperature of 75°C and a pressure of 1.0 MPa). After releasing the PET film on the conductive particle-free layer side, the IC chip was placed thereover with the gold bumps in contact with the conductive particle-free layer. A quartz glass was used as the base for heated pressing at a temperature of 210°C and a pressure of 80 MPa for 5 seconds to obtain a connection structure with a connected section.

(Measurement of initial connection resistance)

A resistance meter (Digital Multimeter, trade name of Advantest Corp.) was used to measure the initial resistance at the connected section of the connection structure fabricated in the manner described above. The measurement was conducted with a current of 1 mA flowing between the electrodes.

(Evaluation of insulation between adjacent electrodes)

The insulation resistance between adjacent electrodes was measured in the following manner using a resistance meter (Digital Multimeter, trade name of Advantest Corp.). First, a direct current (DC) of 50 V was applied for 1 minute at the connected section of the connection structure. The insulation resistance was measured by the two-terminal measuring method at the connected section after voltage application. A voltmeter (ULTRA HIGH RESISTANCE METER, trade name of Advantest Corp.) was used for application of the voltage.

(Evaluation of change in connection resistance with time)

Next, the time-dependent increase in resistance value at the connected section was evaluated by a temperature cycling test. The temperature cycling test was conducted with the connection structure housed in a temperature cycling bath (NT 1020, trade name of ETAC), using a temperature cycle of decrease from room temperature to -40°C, increase from -40°C to 100°C and decrease from 100°C to room temperature, repeated 500 times. The holding time was 30 minutes at both -40°C and 100°C. The resistance at the connected section after the temperature cycling test was measured in the same manner as for the initial resistance.

Table 1 shows the obtained results, together with the conductive particle coverage factors and the crosslinking degrees of the organic high molecular compounds composing the insulating coatings.

(Example 2)

Conductive particles, a circuit-connecting material and a connection structure were produced in the same manner as Example 1, except that a crosslinked acrylic resin with a crosslinking degree of 10% (MP Series, trade name of Soken Chemical & Engineering Co., Ltd., gel fraction: 8%) was used instead of the crosslinked acrylic resin with a crosslinking degree of 20%. The conductive particle coverage factor was 25%.

(Example 3)

Conductive particles, a circuit-connecting material and a connection structure were produced in the same manner as Example 1, except that the insulating coating was formed on the surface of the nucleus particles in the following manner.

Specifically, the same type of nucleus particles as produced in Example 1 and a crosslinked acrylic resin (MP Series, trade name of Soken Chemical & Engineering Co., Ltd., crosslinking degree: 10%, gel fraction: 8%) were introduced into a hybridizer, and conductive particles were formed having the structure shown in Fig. 3. The conditions for the hybridizer were a rotational speed of 16000/min and a reaction tank temperature of 60°C. The conductive particle coverage factor was 30%.

(Example 4)

Conductive particles, a circuit-connecting material and a connection structure were produced in the same manner as Example 1, except that the insulating coating was formed on the surface of the nucleus particles in the following manner.

Specifically, the same type of nucleus particles as produced in Example 1 and a crosslinked acrylic resin (MP Series, trade name of Soken Chemical & Engineering Co., Ltd., crosslinking degree: 13%, gel fraction: 10%) were introduced into a hybridizer, and conductive particles were formed having the structure shown in Fig. 3. The conditions for the hybridizer were a rotational speed of 16000/min and a reaction tank temperature of 60°C. The conductive particle coverage factor was 35%.

(Example 5)

Conductive particles, a circuit-connecting material and a connection structure were produced in the same manner as Example 1, except that the insulating coating was formed on the surface of the nucleus particles in the following manner.

Specifically, the same type of nucleus particles as produced in Example 1 and a crosslinked acrylic resin were introduced into a hybridizer, and conductive particles were formed. The charging weights of the nucleus particles and conductive particles, the hybridizer rotational speed and the reaction tank temperature were appropriately adjusted to obtain conductive particles having the structure shown in Fig. 4. The conductive particle coverage factor was 25%.

(Example 6)

Conductive particles, a circuit-connecting material and a connection structure were produced in the same manner as Example 1, except that the insulating coating was formed on the surface of the nucleus particles in the following manner.

Specifically, the same type of nucleus particles as produced in Example 1 and a crosslinked acrylic resin (MP Series, trade name of Soken Chemical & Engineering Co., Ltd., crosslinking degree: 10%, gel fraction: 8%) were introduced into a hybridizer, and conductive particles were formed. The charging weights of the nucleus particles and conductive particles, the hybridizer rotational speed and the reaction tank temperature were appropriately adjusted to obtain conductive particles having the structure shown in Fig. 4. The conductive particle coverage factor was 25%.

(Example 7)

Conductive particles, a circuit-connecting material and a connection structure were produced in the same manner as Example 1, except that the insulating coating was formed on the surface of the nucleus particles in the following manner.

Specifically, the same type of nucleus particles as produced in Example 1 and a crosslinked acrylic resin (MP Series, trade name of Soken Chemical & Engineering Co., Ltd., crosslinking degree: 13%, gel fraction: 10%) were introduced into a hybridizer, and conductive particles were formed. The charging weights of the nucleus particles and conductive particles, the hybridizer rotational speed and the reaction tank temperature were appropriately adjusted to obtain conductive particles having the structure shown in Fig. 4. The conductive particle coverage factor was 25%.

(Comparative Example 1)

A circuit-connecting material and a connection structure were produced in the same manner as Example 1, except that no insulating coating was formed on the surface of the nucleus particles, and these nucleus particles were used instead of conductive particles with an insulating coating.

(Comparative Example 2)

Conductive particles, a circuit-connecting material and a connection structure were produced in the same manner as Example 1, except that the insulating coating was formed on the surface of the nucleus particles in the following manner.

Specifically, the same type of nucleus particles as produced in Example 1 and a crosslinked acrylic resin (MP Series, trade name of Soken Chemical & Engineering Co., Ltd., crosslinking degree: 10%, gel fraction: 8%) were introduced into a hybridizer, and conductive particles were formed having the structure shown in Fig. 3. The conditions for the hybridizer were a rotational speed of 16000/min and a reaction tank temperature of 60°C. The conductive particle coverage factor was 10%.

(Comparative Example 3)

Conductive particles, a circuit-connecting material and a connection structure were produced in the same manner as Example 1, except that the insulating coating was formed on the surface of the nucleus particles in the following manner.

Specifically, the same type of nucleus particles as produced in Example 1 and a crosslinked acrylic resin (MP Series, trade name of Soken Chemical & Engineering Co., Ltd., crosslinking degree: 10%, gel fraction: 8%) were introduced into a hybridizer, and conductive particles were formed having the structure shown in Fig. 3. The conditions for the hybridizer were a rotational speed of 16000/min and a reaction tank temperature of 60°C. The conductive particle coverage factor was 50%.

(Comparative Example 4)

Conductive particles, a circuit-connecting material and a connection structure were produced in the same manner as Example 1, except that the insulating coating was formed on the surface of the nucleus particles in the following manner.

Specifically, the same type of nucleus particles as produced in Example 1 and a crosslinked acrylic resin (MP Series, trade name of Soken Chemical & Engineering Co., Ltd., crosslinking degree: 3%, gel fraction: 2%) were introduced into a hybridizer, and conductive particles were formed having the structure shown in Fig. 3. The conditions for the hybridizer were a rotational speed of 16000/min and a reaction tank temperature of 60°C. The conductive particle coverage factor was 50%.

(Comparative Example 5)

Conductive particles, a circuit-connecting material and a connection structure were produced in the same manner as Example 1, except that the insulating coating was formed on the surface of the nucleus particles in the following manner.
Specifically, the same type of nucleus particles as produced in Example 1 and a crosslinked acrylic resin (MP Series, trade name of Soken Chemical & Engineering Co., Ltd., crosslinking degree: 20%, gel fraction: 18%) were introduced into a hybridizer, and conductive particles were formed having the structure shown in Fig. 3. The conditions for the hybridizer were a rotational speed of 16000/min and a reaction tank temperature of 60°C. The conductive particle coverage factor was 25%.

(Comparative Example 6)

Conductive particles, a circuit-connecting material and a connection structure were produced in the same manner as Example 1, except that the insulating coating was formed on the surface of the nucleus particles in the following manner.
Specifically, the same type of nucleus particles as produced in Example 1 and a crosslinked acrylic resin (MP Series, trade name of Soken Chemical & Engineering Co., Ltd., crosslinking degree: 10%, gel fraction: 8%) were introduced into a hybridizer. The charging weights of the nucleus particles and conductive particles, the hybridizer rotational speed and the reaction tank temperature were appropriately adjusted to obtain conductive particles having the structure shown in Fig. 4. The conductive particle coverage factor was 10%.

(Comparative Example 7)

Conductive particles, a circuit-connecting material and a connection structure were produced in the same manner as Example 1, except that the insulating coating was formed on the surface of the nucleus particles in the following manner.
Specifically, the same type of nucleus particles as produced in Example 1 and a crosslinked acrylic resin (MP Series, trade name of Soken Chemical & Engineering Co., Ltd., crosslinking degree: 3%, gel fraction: 2%) were introduced into a hybridizer. The charging weights of the nucleus particles and conductive particles, the hybridizer rotational speed and the reaction tank temperature were appropriately adjusted to obtain conductive particles having the structure shown in Fig. 4. The conductive particle coverage factor was 50%.

(Comparative Example 8)

Conductive particles, a circuit-connecting material and a connection structure were produced in the same manner as Example 1, except that the insulating coating was formed on the surface of the nucleus particles in the following manner.
Specifically, the same type of nucleus particles as produced in Example 1 and a crosslinked acrylic resin (MP Series, trade name of Soken Chemical & Engineering Co., Ltd., crosslinking degree: 20%, gel fraction: 18%) were introduced into a hybridizer. The charging weights of the nucleus particles and conductive particles, the hybridizer rotational speed and the reaction tank temperature were appropriately adjusted to obtain conductive particles having the structure shown in Fig. 4. The conductive particle coverage factor was 25%.
Tables 1-4 show the parameters for the conductive particles produced in Examples 2-7 and Comparative Examples 1-8. The results of measurements conducted in the same manner as Example 1 are also shown in Tables 1-4.
[Table 1]

|  | Example 1 | Example 2 | Example 3 | Example 4 |
|---|---|---|---|---|
| Conductive particle coverage factor, % | 25 | 25 | 30 | 35 |
| Organic high molecular compound crosslinking degree, % | 20 | 10 | 10 | 13 |
| Particle size ratio ($D_2/D_1$) | 0.05 | 0.06 | 0.06 | 0.05 |
| Connection resistance (initial), $\Omega$ | <1 | <1 | <1 | <1 |
| Connection resistance (after temperature cycling test), $\Omega$ | <1 | <1 | <1 | <1 |

(continued)

|  | Example 1 | Example 2 | Example 3 | Example 4 |
|---|---|---|---|---|
| Insulation resistance (initial), $\Omega$ | $>10^{12}$ | $>10^{12}$ | $>10^{12}$ | $>10^{12}$ |

[Table 2]

|  | Example 5 | Example 6 | Example 7 |
|---|---|---|---|
| Conductive particle coverage factor, % | 25 | 25 | 35 |
| Organic high molecular compound crosslinking degree, % | 20 | 10 | 13 |
| Thickness/particle size ratio ($T_2/D_1$) | 0.06 | 0.06 | 0.06 |
| Connection resistance (initial), $\Omega$ | <1 | <1 | <1 |
| Connection resistance (after temperature cycling test), $\Omega$ | <1 | <1 | <1 |
| Insulation resistance (initial), $\Omega$ | $>10^{12}$ | $>10^{12}$ | $>10^{12}$ |

[Table 3]

|  | Comp. Example 1 | Comp. Example 2 | Comp. Example 3 | Comp. Example 4 | Comp. Example 5 |
|---|---|---|---|---|---|
| Conductive particle coverage factor, % | 0 | 10 | 50 | 50 | 25 |
| Organic high molecular compound crosslinking degree, % | - | 10 | 10 | 3 | 20 |
| Particle size ratio ($D_2/D_1$) | - | 0.06 | 0.06 | 0.05 | 0.15 |
| Connection resistance (initial), $\Omega$ | <1 | <1 | 4 | 2 | 6 |
| Connection resistance (after temperature cycling test), $\Omega$ | <1 | <1 | >15 | >5 | >18 |
| Insulation resistance (initial), $\Omega$ | $<10^{4}$ | $<10^{4}$ | $>10^{12}$ | $<10^{8}$ | $>10^{12}$ |

[Table 4]

|  | Comp. Example 6 | Comp. Example 7 | Comp. Example 8 |
|---|---|---|---|
| Conductive particle coverage factor, % | 10 | 50 | 25 |

(continued)

|  | Comp. Example 6 | Comp. Example 7 | Comp. Example 8 |
|---|---|---|---|
| Organic high molecular compound crosslinking degree, % | 10 | 3 | 20 |
| Thickness/particle size ratio ($T_2/D_1$) | 0.06 | 0.06 | 0.15 |
| Connection resistance (initial), $\Omega$ | <1 | 6 | 8 |
| Connection resistance (after temperature cycling test), $\Omega$ | <1 | >20 | >23 |
| Insulation resistance (initial), $\Omega$ | $<10^4$ | $>10^{12}$ | $>10^{12}$ |

**Industrial Applicability**

According to the invention it is possible to provide conductive particles that can exhibit a sufficiently low initial resistance value at connected sections and excellent insulation between adjacent circuit electrodes, when circuit members comprising fine-sized circuit electrodes are connected together, and that adequately inhibit increase in the resistance value at the connected sections with time, as well as an adhesive composition and a circuit-connecting material employing the foregoing. It is also possible to provide a connection structure in which circuit members are connected using the aforementioned circuit-connecting material, and a circuit member connecting method by which the structure can be obtained.

**Claims**

1.  A conductive particle comprising:

    a conductive nucleus particle; and
    an insulating coating containing an organic high molecular compound on the surface of the nucleus particle,

    wherein the coverage factor as defined by the following formula (1) is in the range of 20-40%.

$$\text{Coverage factor (\%)} = \frac{\left[\begin{array}{c}\text{Area of sections on nucleus particle}\\\text{surface covered with insulating coating}\end{array}\right]}{\left[\text{Total surface area of nucleus particle}\right]} \times 100 \quad (1)$$

2.  The conductive particle according to claim 1, wherein the organic high molecular compound has a crosslinking degree in the range of 5-20%.

3.  The conductive particle according to claim 1 or 2, wherein the insulating coating is composed of a plurality of insulating particles containing an organic high molecular compound, formed on the surface of the nucleus particle, and the ratio ($D_2/D_1$) of the particle size ($D_2$) of the insulating particles and the particle size ($D_1$) of the nucleus particles is no greater than 1/10.

4.  The conductive particle according to claim 1 or 2, wherein the insulating coating is composed of an insulating layer containing an organic high molecular compound, formed on the surface of the nucleus particle, and the ratio ($T_2/D_1$) of the insulating layer thickness ($T_2$) and the particle size ($D_1$) of the nucleus particles is no greater than 1/10.

5.  An adhesive composition comprising:

    an adhesive component with an adhesive property; and
    conductive particles according to any one of claims 1 to 4 dispersed in the adhesive component.

6. A circuit-connecting material composed of an adhesive composition according to claim 5, which is used for bonding between circuit members and for electrical connection between the circuit electrodes of the circuit members.

7. A connection structure comprising:

a pair of mutually opposing circuit members; and
connected sections that are composed of a cured circuit-connecting material according to claim 6 and that lie between the opposing circuit members to bond the circuit members together so that the respective circuit electrodes of the circuit members are electrically connected together.

8. The connection structure according to claim 7, wherein at least one of the pair of circuit members is an IC chip.

9. The connection structure according to claim 7 or 8, wherein at least one surface of the circuit electrodes of the pair of circuit members is composed of at least one metal selected from among gold, silver, tin, ruthenium, rhodium, palladium, osmium, iridium, platinum and indium tin oxide.

10. The connection structure according to any one of claims 7 to 9, wherein the contacting side of at least one of the pair of circuit members contacting the connected section in the connection structure of the invention includes a section composed of at least one material selected from among silicon nitride, silicone compounds and polyimide resins.

11. A circuit member connecting method wherein a circuit-connecting material according to claim 6 is situated between a pair of mutually opposing circuit members and the assembly is heated and pressed, to form connected sections which are composed of the cured circuit-connecting material and lie between the pair of circuit members, bonding the circuit members together so that the respective circuit electrodes of the circuit members are electrically connected together, thus producing a connection structure comprising the pair of circuit members and connected sections.

*Fig.1*

# Fig.2

# *Fig.3*

10A

2A

1a ⎫
     ⎬ 1
1b ⎭

# *Fig.4*

*Fig.5*

50

60

# Fig.6

(a)

(b)

(c)

# Fig.7

## INTERNATIONAL SEARCH REPORT

| | International application No. |
|---|---|
| | PCT/JP2007/057978 |

A. CLASSIFICATION OF SUBJECT MATTER
*H01B5/00*(2006.01)i, *C09J9/02*(2006.01)i, *C09J11/00*(2006.01)i, *C09J201/00*
(2006.01)i, *H01B1/20*(2006.01)i, *H05K3/32*(2006.01)i

According to International Patent Classification (IPC) or to both national classification and IPC

B. FIELDS SEARCHED

Minimum documentation searched (classification system followed by classification symbols)
H01B5/00, C09J9/02, C09J11/00, C09J201/00, H01B1/20, H05K3/32

Documentation searched other than minimum documentation to the extent that such documents are included in the fields searched
Jitsuyo Shinan Koho          1922-1996   Jitsuyo Shinan Toroku Koho   1996-2007
Kokai Jitsuyo Shinan Koho    1971-2007   Toroku Jitsuyo Shinan Koho   1994-2007

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | WO 03/25955 A1  (Sekisui Chemical Co., Ltd.),<br>27 March, 2003 (27.03.03),<br>Full text<br>& US 2006/154070 A      & EP 1426979 A1 | 1-9,11<br>2-4,10 |
| X<br>Y | JP 7-105716 A  (Soken Chemical & Engineering<br>Co., Ltd.),<br>21 April, 1995 (21.04.95),<br>Full text<br>(Family: none) | 1,4-9,11<br>2-4,10 |
| X<br>Y | JP 2004-146261 A  (Sekisui Chemical Co., Ltd.),<br>20 May, 2004 (20.05.04),<br>Full text<br>(Family: none) | 1-9,11<br>2,10 |

☒ Further documents are listed in the continuation of Box C.    ☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>24 July, 2007 (24.07.07) | Date of mailing of the international search report<br>31 July, 2007 (31.07.07) |
|---|---|
| Name and mailing address of the ISA/<br>Japanese Patent Office | Authorized officer |
| Facsimile No. | Telephone No. |

Form PCT/ISA/210 (second sheet) (April 2005)

**INTERNATIONAL SEARCH REPORT**

International application No.

PCT/JP2007/057978

C (Continuation).    DOCUMENTS CONSIDERED TO BE RELEVANT

| Category* | Citation of document, with indication, where appropriate, of the relevant passages | Relevant to claim No. |
|---|---|---|
| X<br>Y | JP 2005-203319 A  (Sekisui Chemical Co., Ltd.),<br>28 July, 2005 (28.07.05),<br>Full text<br>(Family: none) | 1-9,11<br>2-4,10 |
| X<br>Y | JP 2005-197091 A  (Hitachi Chemical Co., Ltd.),<br>21 July, 2005 (21.07.05),<br>Full text<br>& EP 1702968 A          & WO 2005/66298 A1 | 1-11<br>2-4,10 |
| X<br>Y | JP 2005-149764 A  (Sekisui Chemical Co., Ltd.),<br>09 June, 2005 (09.06.05),<br>Full text<br>(Family: none) | 1-9,11<br>2-4,10 |

Form PCT/ISA/210 (continuation of second sheet) (April 2005)

## INTERNATIONAL SEARCH REPORT

International application No.

PCT/JP2007/057978

**Box No. II    Observations where certain claims were found unsearchable (Continuation of item 2 of first sheet)**

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

**Box No. III    Observations where unity of invention is lacking (Continuation of item 3 of first sheet)**

This International Searching Authority found multiple inventions in this international application, as follows:
   (See extra sheet.)

1. ☐ As all required additional search fees were timely paid by the applicant, this international search report covers all searchable claims.

2. ☒ As all searchable claims could be searched without effort justifying an additional fee, this Authority did not invite payment of any additional fee.

3. ☐ As only some of the required additional search fees were timely paid by the applicant, this international search report covers only those claims for which fees were paid, specifically claims Nos.:

4. ☐ No required additional search fees were timely paid by the applicant.   Consequently, this international search report is restricted to the invention first mentioned in the claims; it is covered by claims Nos.:

**Remark on Protest**
the

☐ The additional search fees were accompanied by the applicant's protest and, where applicable, payment of a protest fee..

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (April 2005)

| **INTERNATIONAL SEARCH REPORT** | International application No. |
|---|---|
| | PCT/JP2007/057978 |

Continuation of Box No.III of continuation of first sheet(2)

A group of claimed inventions can be considered to comply with the requirement of unity of invention only when there is a special technical feature which so links the group of inventions as to form a single general inventive concept. Claims 1-11 seemingly shear an only one common matter "a conductive particle comprising: a core particle having an electrical conductivity; and a insulating coating provided on the surface of the core particle and comprising an organic polymeric compound, wherein the conductive particle has a coverage ratio 20 to 40%" as recited in claim 1.

However, the common matter cannot be regarded as a special technical feature, since the common matter is already disclosed in prior art documents including the following documents.

Document 1: WO 03/25955 A1 (Sekisui Chemical Co., Ltd.) 27 March, 2003 (27.03.03)

Document 2: JP 7-105716 A (Soken Chemical & Engineering Co., Ltd.) 21 April, 1995 (21.04.95)

Document 3: JP 2004-146261 A (Sekisui Chemical Co., Ltd.) 20 May, 2004 (20.05.04)

Document 4: JP 2005-203319 A (Sekisui Chemical Co., Ltd.) 28 July, 2005 (28.07.05)

Document 5: JP 2005-197091 A (Hitachi Chemical Co., Ltd.) 21 July, 2005 (21.07.05)

Document 6: JP 2005-149764 A (Sekisui Chemical Co., Ltd.) 09 June, 2005 (09.06.05)

Therefore, there is found no special technical feature which so links the group of inventions of claims 1-11 as to form a single general inventive concept. Consequently, it is obvious that a group of inventions of claims 1-11 do not comply with the requirement of unity of invention.

Form PCT/ISA/210 (extra sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 8279371 A
- JP 2794009 B
- JP 2001195921 A